# EUROPÄISCHE PATENTANMELDUNG

(11) **EP 1 063 050 A2**
(43) Veröffentlichungstag der Anmeldung: **27.12.2000**
(21) Anmeldenummer: 00111286.1
(22) Anmeldetag: 25.05.2000
(51) Int. Cl.: B23Q 3/08, B25B 11/00, H01L 21/68

(54) **Mobiler Werkstückträger und Verfahren zu dessen Verwendung**

(30) Priorität: 23.06.1999 DE 19928799
(71) Anmelder: SIEMENS AKTIENGESELLSCHAFT, 80333 München (DE)
(72) Erfinder: Kloke, Wolfgang, 83104 Tuntenhausen (DE)

(57) **Zusammenfassung**

Es wird ein mobiles System aus einem Träger und einem darauf aufliegenden fixierten und eben ausgerichteten Wafer 1 beschrieben, das als eine montierte Einheit durch eine Prozessierungslinie für den Wafer transportiert werden kann.

## Beschreibung

Die Erfindung betrifft einen mobilen Werkstückträger für dünne Wafer, die fixiert und eben ausgerichtet werden müssen, sowie ein Verfahren zur Verwendung dieser Vorrichtung.

Zur Herstellung von elektronischen Bauelementen werden Halbleitermaterialien in Form von sogenannten Wafern verwendet. Auf einer solchen, meist kreisrunden, Scheibe wird eine Vielzahl von integrierten Schaltungen in Bearbeitungsstationen und Fertigungslinien aufgebracht. Hierzu muß ein Wafer schrittweise von einer Fertigungseinheit zur nächsten transportiert werden. Wesentlich dabei ist die Erkennung, Fixierung und relative Ausrichtung des Wafers zu jeder Bearbeitungseinheit.

Im Zuge der technischen Entwicklung werden zunehmend Wafer mit einem größeren Durchmesser verwendet, wobei Durchmesser von 5 bis 6 Zoll realisiert und Durchmesser von 8 Zoll zu erwarten sind. Darüber hinaus wird versucht, die Materialstärke dieser Wafer weiter zu verkleinern. Dabei ist allgemein mit einem Verzug dieser Wafer von bis zu 10 mm bei einem Durchmesser von 5 Zoll bezogen auf eine ebene Ausrichtung des Wafers zu rechnen. In den für den Wafer vorgesehenen Prozeßschritten kann bei derartigen Verformungen nicht mit automatischen Handlingsystemen (Handhabungssystemen) gearbeitet werden. In den meisten Fällen kann ein derart verzogener Wafer nicht in einer Einheit berarbeitet werden.

Das Problem der Verbiegung ist mit der Verwendung von extrem dünnen Wafern aktuell aufgetreten. Diese Wafer sind fast ausnahmslos deformiert. Eine weitere Abnahme der Schichtstärke von Wafern würde in Zukunft noch größere Probleme aufwerfen. Diese Scheibeninstabilität führt dazu, daß bisherige Handhabungssysteme für die Wafer versagen.

Der Erfindung liegt die Aufgabe zugrunde, eine Vorrichtung und ein Verfahren zur Verfügung zu stellen, womit deformierte Wafer fixiert und einheitlich ausgerichtet in einem System durch Bearbeitungsprozesse transportiert werden können.

Die Lösung dieser Aufgabe geschieht durch die Merkmalskombination von Anspruch 1 bzw. Anspruch 11.

Der Erfindung liegt die Erkenntnis zugrunde, daß instabile und verbogene Wafer sich in Bearbeitungsprozessen sowie vor- und nachgeschaltet, auf Transportstrecken fertigungssicher bearbeiten bzw. handhaben lassen, wenn ein Trägersystem eingesetzt wird, das den Wafer festhält, eben ausrichtet und mobil ist. Die Funktion eines solchen Trägers wird durch Haltemittel bewirkt, die entweder durch Unterdruck oder durch elektrostatische Kräfte den Wafer auf dem Träger festhalten. Zur Beseitigung einer Deformation des Wafers wird dieser, falls er nicht bei aufgebrachter Haltekraft bereits eine ebene Ausrichtung erfahren hat, durch eine äußere aufgebrachte Kraft derart geformt, daß er eine ebene Gestalt annimmt.

Die Aufbringung einer Haltekraft durch in dem Träger vorhandene Haltekräfte kann vorteilhafterweise durch Unterdruckkammern bewerkstelligt werden. Prinzipiell können eine oder auch mehrere Unterdruckkammern zum Einsatz kommen. Die Kammern sind beispielsweise bei einer ringförmigen Ausgestaltung des Trägers in diesem Ring angeordnet, weisen stirnseitig Auflageflächen auf, die in einer einzigen Ebene liegen und zudem mit Ansaugdüsen bestückt sind, die in Verbindung mit Unterdruckkammern stehen. Über ein Ventil werden die Unterdruckkammern nach dem Auflegen eines Wafers evakuiert, wobei nach Schließung des Ventils Unterdruck-Versorgungsleitungen vom Träger demontiert werden.

Zur Aufbringung einer Haltekraft kann in vorteilhafter Weise auch eine elektrostatische Kraft auf den Wafer aufgebracht werden, durch die dieser an dem Träger gehalten wird. Dies geschieht über den Einsatz von Dielektrika, die ähnlich wie Ansaugdüsen über einen Träger oder über einen Trägerring verteilt sind. Elektrische Versorgungsleitungen werden dabei ebenfalls demontiert, sobald der Wafer aufgelegt und fixiert ist. Durch entsprechende Isolierung wird die vorhandene Polarisation auch ohne Spannungsversorgung die elektrostatische Haltekraft noch längere Zeit bewahrt bleiben.

Der Grundkörper eines beschriebenen Trägers für Wafer ist in vorteilhafter Weise aus Metall oder aus Kunststoff hergestellt. Dadurch wird gewährleistet, daß er in sich stabil ist, den Wafer ausreichend stützen kann und auch in aggressiven Umgebungen einsetzbar ist.

Eine vorteilhafte Ausgestaltung sieht vor, daß bei der Aufbringung der Haltekraft durch Unterdruck in einem Hohlraum, einer Unterdruckkammer, eine Membran angebracht ist, die einen Teil des Hohlraumes abschließt. Durch diese sogenannte Unterdruckmembran wird gewährleistet, daß der anliegende Unterdruck eine bestimmte Elastizität aufweist, so daß die Zeit verlängert wird, in der der Unterdruck ohne äußere Versorgung beibehalten werden kann.

Es ist besonders vorteilhaft, die Ansaugdüsen oder die Auflageflächen mit Dichtungslippen zu versehen, so daß die Beständigkeit des Unterdruckes erhöht wird und die Lagerung des Wafers stark gedämpft ist.

Weitere vorteilhafte Ausgestaltungen sind den Unteransprüchen zu entnehmen.

Das Verfahren zur Fixierung und Ausrichtung von Wafern auf einem entsprechenden Träger sieht vor, daß ein Träger mit einem Wafer ein System bildet, daß einen zunächst verbogenen Wafer aufnimmt, fixiert, an den Auflageflächen ausrichtet und durch eine Vielzahl von Prozessierungseinheiten transportiert.

Im folgenden werden anhand von schematischen Figuren Ausführungsbeispiele beschrieben.
- Figur 1: zeigt den Querschnitt durch einen Trägerring 3 mit Hohlräumen 7 als Unterdruckkammern sowie einen relativ dazu positionierten Wafer 1,
- Figur 2: zeigt entsprechend der Einzelheit II aus Figur 1 einen Hohlraum 7 mit einem aufgesetzten Wafer 1,
- Figur 3: zeigt den Trägerring 3 in der Aufsicht,
- Figur 4: zeigt andere Ausgestaltungen des Trägers, die mit entsprechenden Ansaugdüsen bestückt sind,
- Figur 5: zeigt den Schnitt durch einen Trägerring 3, wobei ein Dielektrikum 10 zur Erzeugung von elektrostatischen Kräften vorgesehen ist.

Die Geometrie eines Trägers für einen Wafer mit den oben beschriebenen Funktionen kann sehr unterschiedlich ausgebildet sein. Im Extremfall, wenn die Bearbeitung des Wafers ausschließlich frontseitig geschieht, ist der Träger vollflächig ausgebildet und nimmt einen Wafer auf, wobei lediglich Aussparungen auf den Auflageflächen in Form von Ansaugdüsen vorhanden sind. Diese Variante würde schließt jedoch eine Rückseitenprozessierung des Wafers vollständig aus, so daß der Wafer lediglich auf der Vorderseiten prozessiert werden kann. Sinnvollerweise wird der Träger derart ausgebildet, daß die Auflageflächen des Trägers den Wafer an den Stellen unterstützen, an denen keine Prozessierung stattfindet. Dies ist in der Regel der Außenrandbereich eines kreisrunden Wafers. Ein somit ringförmiger Träger gewährt bei der Prozessierung einen Zugang zur gesamten Vorderseite und einen Zugang zu dem überaus größten Bereich der Rückseite des Wafers. Der Trägerring oder die Trägerfläche kann je nach Bedarfsfall Unterbrechungen aufweisen, so daß Segmente des Trägerringes gleichmäßig verteilt über den Umfang vorhanden sind. Diese können beispielsweise nierenförmige Ausbildungen aufweisen. Die Ansaugdüsen sind möglichst gleichmäßig zu verteilen und können durch Bohrungen oder durch Längsschlitze dargestellt werden.

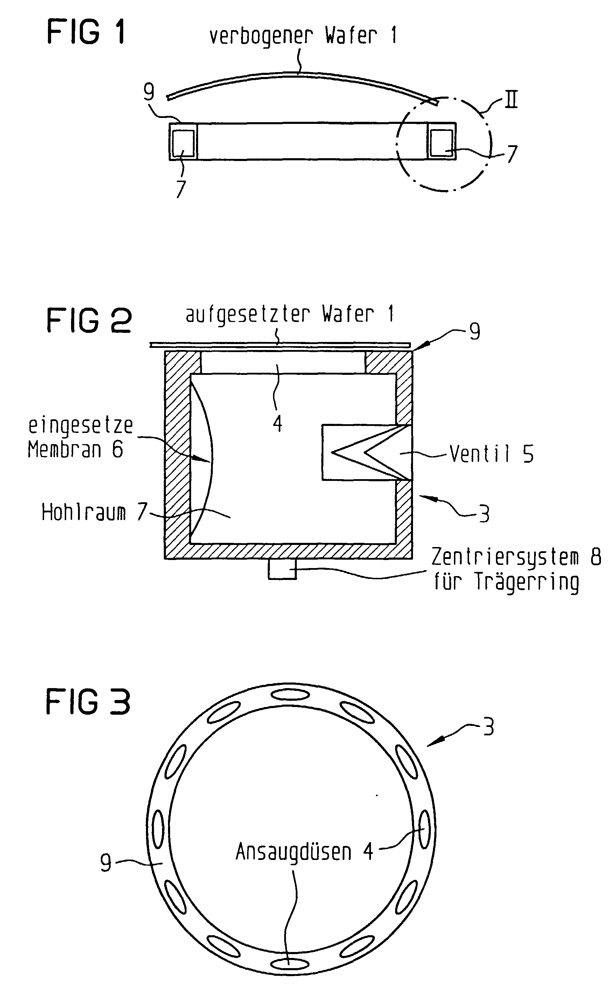

Die Figur 2 zeigt insbesondere den Schnitt durch einen Trägerring mit einem Hohlraum 7, an dessen Wandungen sich ein Ventil 5 zur Unterdruckbeaufschlagung und eine Ansaugdüse 4 zum Ansaugen eines aufgesetzten Wafers 1 befinden. Der äußere Rand des Wafers 1 ist rechts oben positioniert. Die Ansaugdüse 4 kann eine von mehreren zu einem einzigen Hohlraum 7 (Unterdruckkammer) gehörenden Ansaugdüsen 4 sein. Andererseits kann die Gestaltung der Hohlräume derart vorgenommen werden, daß jedem Hohlraum 7 eine einzige Ansaugdüse 4 zugeordnet wird. Die eingesetzte Membran 6 dient dazu, ein über das Ventil 5 angelegtes Vakuum über längere Zeit zu halten. Wird über das Ventil 5 ein Unterdruck angelegt und ein Wafer angelegt, so wird im mobilen Zustand des Trägers bzw. Trägerringes, wenn die Versorgungsleitungen demontiert sind und das Ventil 5 geschlossen ist, eine zeitabhängige Leckage zu verzeichnen sein, die den Unterdruck langsam abbaut. Ist nun beim Anlegen des Unterdruckes die Membran 6 entsprechend vergrößert worden, so ist in ihr eine Kraft zwischengespeichert, die bei Verringerung des Unterdrucks im größeren Teil des Hohlraumes 7 dazu dient, den Unterdruck dort über längere Zeit als ohne den Einsatz einer Membran 6 zu halten. Weiterhin ist in Figur 2 ein Zentriersystem 8 für den Trägerring 3 angedeutet, mittels dem das System aus Wafer und Trägerring dreidimensional in jeder Bearbeitungsstation ausgerichtet werden kann.

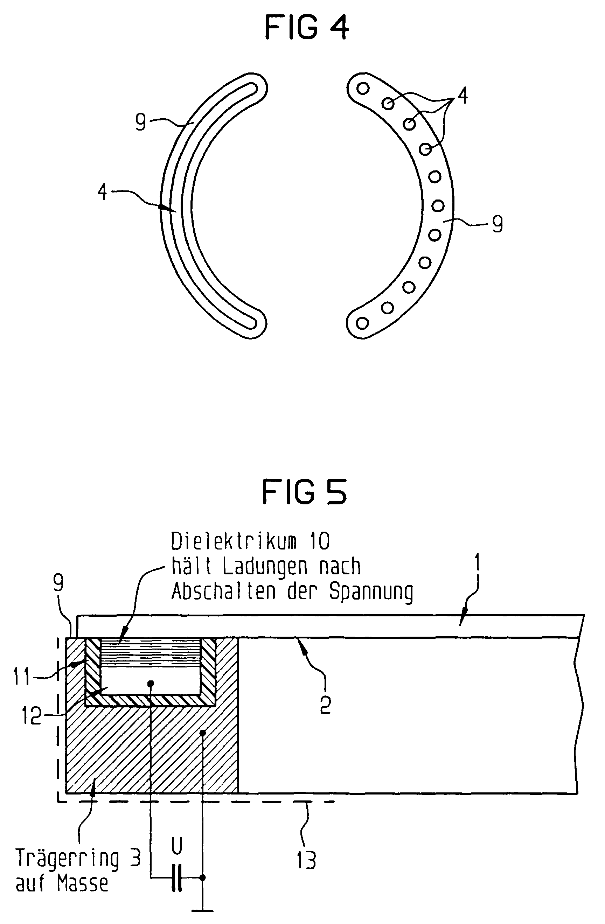

Die Figuren 3 und 4 zeigen in der Aufsicht den Trägerring 3, der auch entsprechend Figur 4 unterbrochen dargestellt werden kann. Die Ansaugdüsen 4 sind in verschiedenen Formen wie kreisrunde bohrungen oder Längsschlietze dargestellt.

Figur 5 zeigt ein Dielektrikum 10, das in dem Trägerring 3 positioniert ist. Die Anzahl von Dielektrika 10 in einem Trägerring 3 wird entsprechend der notwendigen aufzubringenden Haltekraft ausgelegt. In Figur 5 ist dargestellt, daß der Wafer 1 einen kleineren Durchmesser als der Trägerring 3 aufweist. Die Auflagefläche 9 ragt somit über den äußeren Rand des Wafers 1 hinaus. Die Waferunterseite 2 liegt auf der Auflagefläche 9 auf, womit der Wafer parallel ausgerichtet wird und sich zentral im Wafer befindliche Verformungen in der Regel bei der Fixierung des Wafers von alleine beheben. Am rechten Rand von Figur 5 ist als senkrechte Strichpunktlinie die Mittelachse des Systemes dargestellt. Durch Anlegen einer Spannung U zwischen Trägerring, der an Masse liegt, und einer Elektrode 12 wird durch den Einsatz einer Isolierung 11 das Dielektrikum 10 polarisiert und hält diese Ladung eine gewisse Zeit. Eine weitere Isolierung 13 schlirmt den Trägerring 3 nach außen hin ab.

Das Trägersystem ist somit mobil und verfügt weder über Schlauchleitungen noch über elektrische Verbindungen zur Versorgung der Haltemittel. Der Hohlraum 7 oder einzeln evakuierbare Einzelhohlräume des Trägers sind mit einem oder mit mehreren Ventilen nach außen verbunden. Das Ventil dient zur Evakuierung und somit zur Ansaugung des Wafers 1 auf dem Träger. Die Adaptierung dieses Ventils 5 mit einer externen Unterdruckstation erfolgt gleichzeitig mit dem Aufsetzen des Wafers auf dem Träger. Nach dem Erreichen des vorgegebenen Unterdruckes, wenn der Wafer aufgesetzt und fixiert ist, wird die externe Unterdruckstation entkoppelt und der Wafer ist mit dem mobilen Träger vorübergehend fest verbunden.

Konstruktive Optionen bestehen in dem Rahmen, in dem ausreichende Auflageflächen 9 vorhanden sind, um den Wafer eben auszuformen und stabil zu halten. Weiterhin sollten je nach Anforderungsprofil möglichst große Flächen des Wafers zur Prozessierung frei bleiben. Die Auflageflächen lassen sich mit geeigneten Dichtlippen versehen, um die Dichtwirkung und die Dichtzeit zu verlängern. In den Figuren sind keine Dichtlippen eingezeichnet. Der Träger kann über ein Zentriersystem in Form von Füßen verfügen, um eine Ausrichtung oder Verdrehsicherheit mit einzubringen. Somit ist ein System geschaffen, das eine feste Adaptierung von Wafern auf einem mobilen stabilen Träger gewährleistet, das durch eine Vielzahl von Prozeßschritten geschleust werden kann. Um die Biegesteifigkeit von dünnen Wafern bei Prozessierungen zu erhöhen werden diese somit während der Bearbeitungsprozesse auf einen Werkstückträger aufgespannt. Der Träger hält den Wafer 1 von der Unterseite im Randbereich und schützt den bruchempfindlichen Waferrand. Der Träger wird während sämtlicher Bearbeitungsprozesse permanent mit dem Wafer 1 verbunden bleiben. Dabei sind folgende Punkte gewährleistet:
- Die Haltekraft zwischen Wafer und Träger ist ohne externe Energieversorgung während der Bearbeitungsschritte vorhanden,
- das Material des Trägers hält den chemischen und temperaturbedingten Anforderungen in den Bearbeitungsschritten stand,
- die Auflageflächen sind bei der Verwendung eines Trägerringes 3 oder eines vollflächigen Trägers möglichst gering.

## Patentansprüche

1. Mobiler Träger für dünne Wafer, bestehend aus
- einem Grundkörper mit in einer Ebene liegenden Auflageflächen 9 für einen Wafer 1, die einen Wafer 1 partiell unterstützen,
- im Grundkörper integrierten Haltemitteln zur Erzeugung einer Kraft, durch die der Wafer 1 auf den Auflageflächen 9 fixiert und eben ausgerichtet ist, wobei die Haltemittel die Kraft ohne äußere Energiezufuhr aufrecht halten.

2. Mobiler Träger nach Anspruch 1, wobei im Grundkörper mindestens ein mit Unterdruck beaufschlagbarer Hohlraum 7 vorgesehen ist, der mit an den Auflageflächen 9 verteilten Ansaugdüsen 4 in Verbindung steht und über ein Ventil 5 evakuierbar ist und der Wafer 1 durch eine vom Unterdruck erzeugte Kraft fixiert und ausgerichtet ist.

3. Mobiler Träger nach Anspruch 1, wobei im Grundkörper in den Auflageflächen 9 Elemente mit jeweils einem elektrostatisch aufladbaren Dielektrikum 10 vorgesehen sind und der Wafer 1 durch eine vom elektrostatischen Feld erzeugte Kraft fixiert und ausgerichtet ist.

4. Mobiler Träger nach einem der vorhergehenden Ansprüche, wobei der Grundkörper als ein vollflächiger Träger oder Trägerring 3 ausgeführt ist, der den Wafer 1 durch die Haltemittel oder die Auflageflächen 9 unterstützt.

5. Mobiler Träger nach einem der vorhergehenden Ansprüche, wobei der Grundkörper als ein vollflächiger Träger oder Trägerring 3 ausgeführt ist, der an seinem Umfang Unterbrechungen aufweist und wobei einzelne Elemente ringförmig oder nierenförmig ausgebildet sind.

6. Mobiler Träger nach einem der vorhergehenden Ansprüche , wobei der Grundkörper aus Metall, Keramik oder Kunststoff besteht.

7. Mobiler Träger nach Anspruch 2, wobei ein Hohlraum 7 eine Membran 6 aufweist, die einen Teil des Hohlraumes 7 umschließt.

8. Mobiler Träger nach einem der Ansprüche 2 oder 4 bis 7, wobei die Auflageflächen 9 mit Dichtungslippen versehen sind, um bei einem aufliegenden Wafer 1 die Dichtwirkung und die Beständigkeit des Unterdruckes zu erhöhen.

9. Mobiler Träger nach einem der vorhergehenden Ansprüche, wobei der Träger über ein Zentriersystem 8 zur relativen Ausrichtung in einer Fertigungslinie verfügt.

10. Mobiler Träger nach einem der vorhergehenden Ansprüche, wobei der äußere Durchmesser des Grundkörpers größer oder kleiner ist als der Durchmesser des Wafers 1.

11. Verfahren zur Fixierung und Ausrichtung eines Wafers während dessen Prozessierung unter Verwendung eines mobilen Trägers entsprechend einem der Ansprüche 1 bis 10, bestehend aus folgenden Schritten:
- der Wafer 1 wird auf einen Träger aufgebracht und durch Haltemittel an dessen Auflageflächen 9 gehalten,
- der Wafer 1 wird unmittelbar durch das Andrücken oder durch Aufbringen einer äußeren Kraft an nicht ebenen Bereichen des Wafers in eine stabile ebene Form gebracht, so daß er parallel zu der Ebene der Auflageflächen 9 positioniert ist,
- der mobile Träger wird mit dem derart fixierten Wafer 1 durch Fertigungs- und Prozessierungslinien transportiert.

12. Verfahren nach Anspruch 11, wobei der mobile Träger ein Zentriersystem 8 aufweist, über das der Träger und damit auch der Wafer 1 relativ zu Einheiten einer Fertigungslinie dreidimensional positioniert werden können.

13. Verfahren nach einem der Ansprüche 11 oder 12, wobei elektrische oder pneumatische Versorgungsleitungen bis zur Fixierung und ebenen Ausrichtung des Wafers am Träger angeschlossen sind und anschließen getrennt werden, um die Mobilität des Trägers herzustellen.
